Europäisches Patentamt

European Patent Office

Office européen des brevets

(11) Publication number: **0 469 583 A2**

# EUROPEAN PATENT APPLICATION

(21) Application number: **91112887.4**

(22) Date of filing: **31.07.91**

(51) Int. Cl.⁵: **H01L 21/76**

(30) Priority: **31.07.90 JP 203563/90**

(43) Date of publication of application:
**05.02.92 Bulletin 92/06**

(84) Designated Contracting States:
**DE FR GB IT**

(71) Applicant: **Kabushiki Kaisha Toshiba**
**72, Horikawa-cho Saiwai-ku**
**Kawasaki-shi(JP)**

Applicant: **TOSHIBA MICRO-ELECTRONICS**
**CORPORATION**
**25-1, Ekimaehoncho**
**Kawasaki-ku Kawasaki-shi(JP)**

(72) Inventor: **Furukawa, Kazuyoshi, c/o**
**Intellectual Property Div**
**KABUSHIKI KAISHA TOSHIBA, 1-1 Shibaura**
**1-chome**
**Minato-ku, Tokyo 105(JP)**
Inventor: **Tanaka, Kazuhiro, c/o Intellectual**
**Property Div.**
**KABUSHIKI KAISHA TOSHIBA, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Semiconductor substrate with complete dielectric isolation structure and method of making the same.

㊗ For reducing unwanted warpage produced in a semiconductor substrate having dielectrically isolated island regions (111), a first semiconductor substrate (11) for providing circuit elements is bonded through a first insulating film (13) to a second semiconductor substrate (12) serving as a support. A plurality of grooves (16) are then formed in the first semiconductor substrate (11) to expose a surface of the second semiconductor substrate (12), thereby providing a plurality of island regions (111) through the first insulating film (13) thereabove. Thereafter, a second insulating film (17) is formed on the exposed surface of the second semiconductor substrate (12). In the structure, the second insulating film (17) is made thinner than the first insulating film (13) so as to reduce the unwanted warpage produced in the semiconductor substrate (12).

F I G. 1E

The present invention relates to a semiconductor substrate having a complete dielectric isolation structure and a method of making the same.

In a conventional semiconductor device, a p-n junction or a dielectric isolation structure has been well known as an isolation structure. The dielectric isolation structure has the following advantages as compared to the p-n junction isolation structure;

(a) a leakage current is low and an unwanted latch-up phenomenon is not caused even in a high temperature operation,

(b) an area required for the isolation is small even if circuit elements with a high breakdown voltage are isolated from each other;

(c) it is not necessary to consider a polarity of voltage to be applied, and

(d) a parasitic capacitance is low.

Several methods have been known to obtain such a dielectric isolation structure. For example, a method using direct bonding of two substrates, a method of epitaxially growing silicon on a sapphire substrate called an SOS, and a method of recrystallizing amorphous silicon deposited on an insulating film have been known. In addition, the following method has been also known. That is, a part of a silicon wafer is etched to form an oxide film, and a polysilicon layer is deposited thereon. Thereafter, the resultant structure is lapped from its lower surface, thereby obtaining island regions supported by the polysilicon layer and isolated from one another.

Of the above methods, the method using bonding of two substrates is an excellent one having the following characteristics. That is, a thick silicon layer having a high quality is provided as an active layer, and the bonded wafer has a relatively low warpage. A method of making a dielectric isolation substrate using the above bonding will be described below with reference to Figs. 6A to 6D.

Silicon wafers 31 and 32 each having at least one mirror surface are prepared, an oxide film 33 is formed on the surface of one of the silicon wafers 31 and 32. The two wafers 31 and 32 are heat-treated to be integrally boned, while the oxide film 33 is interposed therebetween. Thereafter, the surface of the silicon wafer 32, which serves as an active layer for providing circuit elements therein, is lapped to have a predetermined thickness (Fig. 6A).

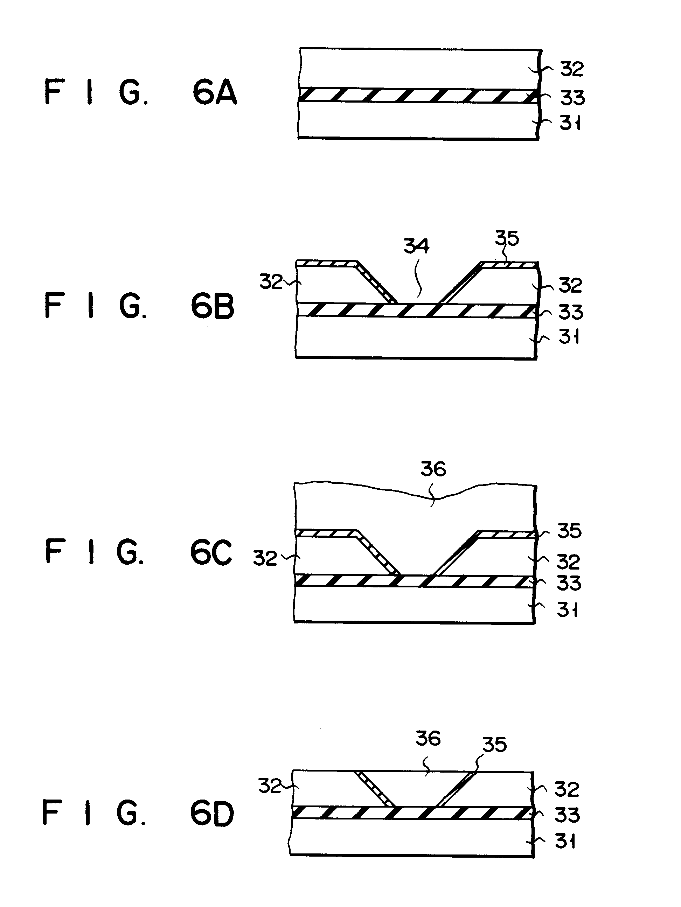

In order to separate the active layer into island regions, the surface of the silicon wafer 32 is selectively etched by anisotropic etching to form a groove 34 having a V-shaped section, and an oxide film 35 is formed on the surface of the silicon wafer 32 (Fig. 6B).

A polysilicon layer 36 is deposited on the entire surface of the oxide film 35 to bury the groove 34 therewith (Fig. 6C).

The deposited surface of the polysilicon layer 36 is lapped by lapping or the like so as to be planarized, thereby obtaining a dielectric isolation substrate (Fig. 6D).

In this case, the thickness of the oxide film 33 is defined by a dielectric breakdown voltage and a capacitance, which are required between the active layer, on which circuit elements are to be provided, and the wafer 31 serving as a support substrate. The oxide film 33 having a thickness of about several $\mu$m is required for circuit element characteristics.

However, when the circuit element characteristics such as a low parasitic capacitance and a high dielectric breakdown voltage are required, the thickness of the oxide film for dielectric isolation must be structurally increased.

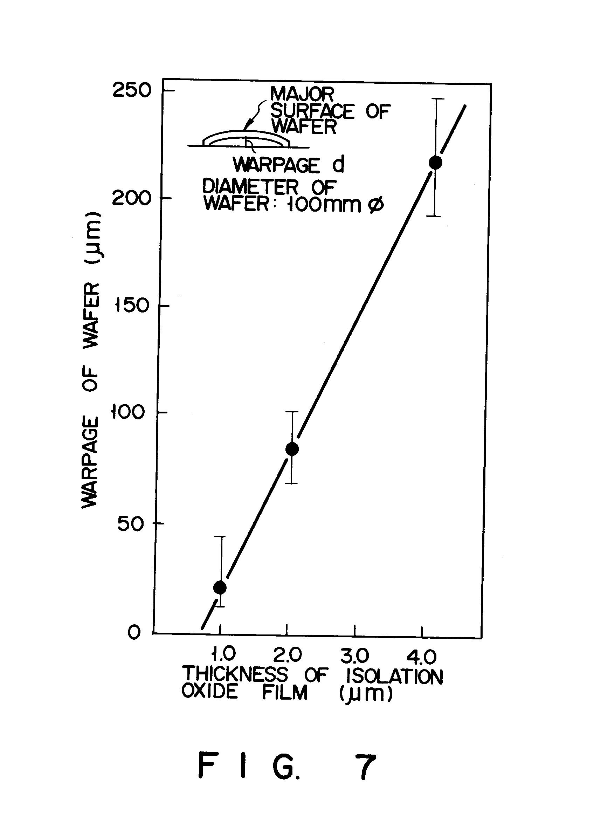

However, when the thickness of the film is increased, a produced warpage is increased due to a difference between a thermal expansion coefficient of silicon and that of the oxide film. For this reason, it is difficult to precisely control the thickness of the island region. Fig. 7 shows a relationship between an isolation oxide film thickness ($\mu$m) and warpage d ($\mu$m) of a wafer, wherein a shift d between the edge and the center of the wafer having a diameter of 100 mm is measured. The warpage is increased in proportion to the thickness of the oxide film. This relationship can be obtained when the wafer has a large diameter. Further, since the warpage d is proportional to the square of the wafer diameter, the substrate is affected by the warpage as increasing the diameter. In a wafer process, when a wafer has the large warpage, a fine PEP (photoetching process) by lithography apparatus or the like is not easily performed.

It is, therefore, an object of the present invention to provide a semiconductor substrate which has a dielectric isolation structure with a reduced warpage.

It is another object of the present invention to provide a semiconductor substrate having a dielectric isolation structure which has a high precision in processing dimensions.

It is still another object of the present invention to provide a method of making a semiconductor substrate which has a dielectric isolation structure with a reduced warpage.

It is still another object of the present invention to provide a method of making a semiconductor substrate having a dielectric isolation structure which has a high precision in processing dimensions.

According to one aspect of the present invention, there is provided a semiconductor substrate having dielectrically isolated island regions, which comprises a first semiconductor substrate for providing circuit elements, a second semiconductor substrate for supporting the first semiconductor substrate, a first insulating film located between the first and second semiconductor substrates, a plurality of grooves formed in the first semiconductor substrate to expose a surface of the second semiconductor substrate, and a second insulating film formed on the exposed surface of the second semiconductor substrate. In the structure, a plurality of island regions are provided above the second semiconductor substrate through the first insulating film and the second insulating film is thinner than the first insulating film so as to reduce unwanted warpage produced in the semiconductor substrate.

According to another aspect of the present invention, there is provided a method of making the semiconductor substrate according to a principle incorporated in the first referred aspect of the present invention.

The novel and distinctive features of the invention are set forth in the claims appended to the present application. The invention itself, however, together with further objects and advantages thereof may best be understood by reference to the following description and accompanying drawings in which:

Figs. 1A to 1H are sectional views sequentially showing steps in making a semiconductor substrate according to the first embodiment of the present invention;

Figs. 2A, 2B, and 3 are sectional views showing a semiconductor substrate according to the second embodiment of the present invention;

Figs. 4 and 5 are sectional views showing a semiconductor substrate according to the third embodiment of the present invention;

Figs. 6A to 6D are sectional views sequentially showing steps in making a conventional semiconductor substrate; and

Fig. 7 is a graph showing a relationship between an oxide film thickness and warpage of a wafer in a semiconductor substrate made by a conventional method.

The present invention will be described below with reference to embodiments in conjunction with the accompanying drawings.

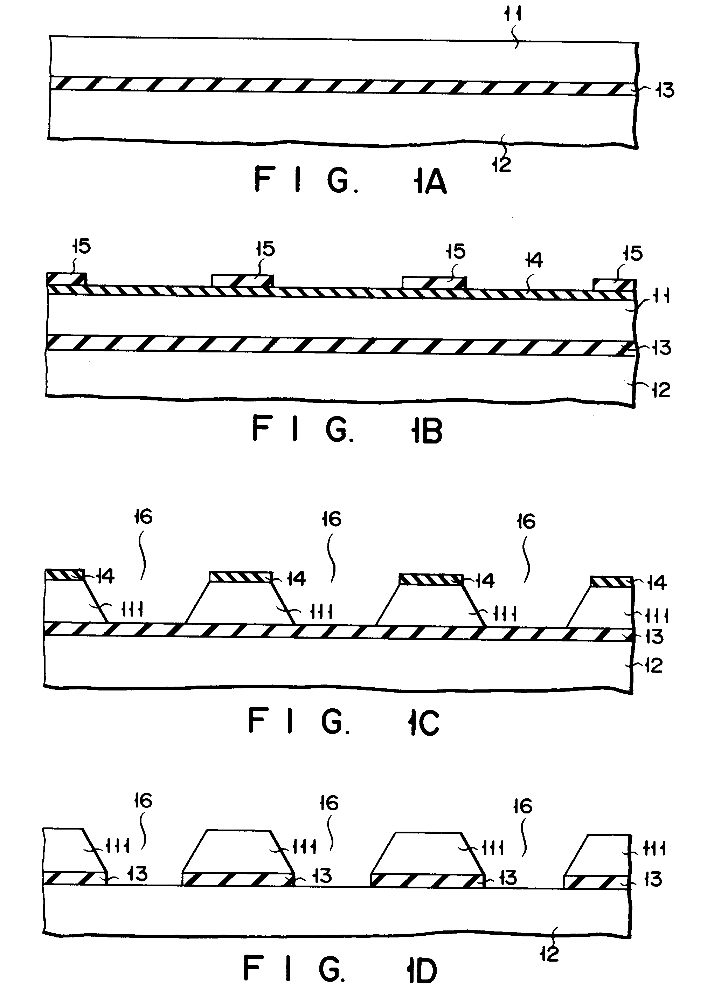

Referring to Figs. 1A to 1G, a semiconductor substrate according to the first embodiment of the present invention and steps in making the same will be described below. First, 20 n-type silicon wafers 11 each having a diameter of 125 mm, a thickness of 625 $\mu$m, a crystal plane of (100), and a resistivity $\rho$ of about 0.15 $\Omega \cdot$cm are prepared, and a thermal oxide film 13 having a thickness of 2 $\mu$m is formed on each of the silicon wafers 11. Independently of the silicon wafers 11, 20 silicon wafers 12 each having a diameter of 125 mm, a thickness of 525 $\mu$m, a crystal plane of (100), and a resistivity of about 40 $\Omega \cdot$cm are prepared. There-

after, each of the wafers 11 and each of the wafers 12 are bonded to each other in a clean atmosphere. The resultant structure is heat-treated in a mixed gas atmosphere, composed of an O$_2$ gas and an N$_2$ gas, at a temperature of 1,100$^\circ$C for 2 hours, thereby providing one complete wafer. The mixed gas is obtained by mixing the O$_2$ gas with the N$_2$ gas at a ratio of 1 : 4. The silicon wafer 11 is lapped to have a thickness of, e.g., 25 $\mu$m (Fig. 1A).

An oxide film 14 is formed on the surface of the wafer 11. An etching mask 15 of a photoresist layer is formed on the oxide film 14 by well-known techniques (Fig. 1B).

After the exposed oxide film 14 is selectively removed, the resultant structure is anisotropically etched by a potassium hydroxide solution, using the remained oxide film 14 as a mask. V-shaped grooves 16 are then formed in the wafer 11, thereby providing a plurality of isolated island regions 111 (Fig. 1C).

The oxide films 13 located on bottoms of the grooves 16 are then removed by an aqueous solution composed of hydrofluoric acid and pure water at a mixing ratio of 1 : 2, thereby exposing the surface of the wafer 12 (Fig. 1D).

At this time, for the sake of comparison, the oxide film 13 located on the bottom of each groove 16 was removed from each of the 10 wafers of the 20 wafers, and the oxide film 13 was not removed from each of the 10 remaining wafers. A measurement of the warpage was then carried out on both wafer groups, using a surface roughness gauge. The following results were obtained. That is, one wafer group with the oxide film 13 had a convex warpage of about 60 $\mu$m, but the other wafer group without the oxide film 13 had the warpage of about 30 $\mu$m.

An oxide film 17 having a thickness of 0.5 $\mu$m is formed on the bottom of each groove 16 and the surface of each island region 111 (Fig. 1E).

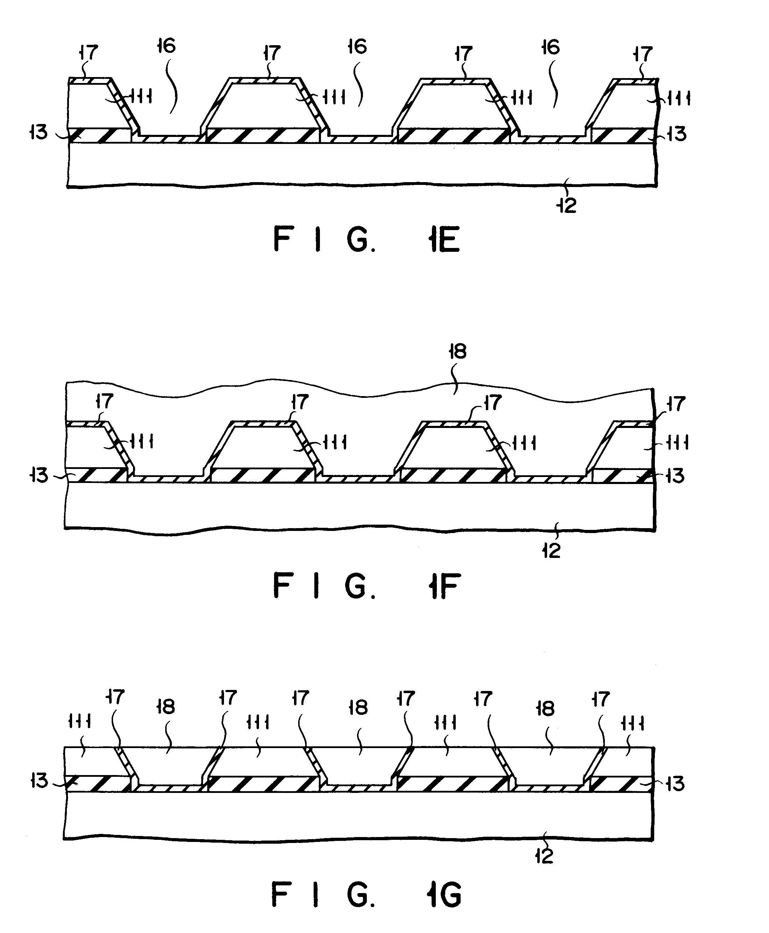

A polysilicon layer 18 is deposited on the entire surface of the resultant structures to have a thickness of 50 $\mu$m (Fig. 1F).

The island regions 111 are lapped to have a thickness of 15 $\mu$m, thereby providing a dielectric isolation substrate (Fig. 1G).

At this time, a measurement of the warpage was again carried out on both dielectric isolation substrate groups, using the surface roughness gauge. The following results were obtained. That is, one substrate group, which newly included the thin oxide film 17 on the bottom of each groove 16 after removing the oxide film 13 therefrom, had the warpage of about 50 $\mu$m, and the variation in the island thickness was 15 ± 2 $\mu$m. On the contrary, the other substrate group, which included the oxide film 13 remained on the bottom of each groove 16, had the warpage of about 100 $\mu$m, and the variation in the island thickness was 15 ± 6 $\mu$m.

Further, both substrate groups had the dielectric breakdown voltage of 1300 - 1500 V between each island region 111 and the support wafer 12, and had also the similar capacitance values to each other.

The oxide film 13 located on each of the bottoms of the grooves 16 is completely removed as shown in Fig. 1D. However, without completely removing the oxide film 13, the substrate may be etched so as to leave a thin oxide film 130 as shown in Fig. 1H.

As described above, since the thickness of the oxide film 17 located between the bottom portions of the grooves 16 and the wafer 12 is sufficiently reduced as compared with the oxide film 13 located between the wafer 11 and wafer 12, the amount of the warpage can be reduced. As a result, when circuit elements are provided using the dielectric isolation substrate having the structure shown in Fig. 1G, the thickness of the wafer 11 can be precisely controlled, processing precision can be improved, and the diameter of the wafer 11 can be increased. In addition, since the dielectric isolation substrate has the small warpage, fine PEP or the like can be easily performed by lithography apparatus in the wafer process.

As the thickness of the oxide film 17 is reduced, good results can be obtained. In addition, as the area of the groove or the area of the thin oxide film is increased, good advantages can be obtained. At this time, the oxide film formed on the bottom of each groove was once removed by etching, and the exposed support wafer surface was oxidized to provide a thin oxide film thereon. In such a substrate the area of the groove and the film thickness were changed to investigate the advantages. As a result, when the length of each short side of a rectangular island was given by 2 mm or less, remarkable advantages could be obtained. According to the result, the warpage was reduced because the thickness of the oxide film formed on the bottom of the groove was decreased. The reason for the reduction of the warpage did not merely depend upon the reduction of the total amount of the oxide films. Therefore, the result shows that a stress is released by isolating the thick oxide film into a large number of parts. In addition, when the ratio of the grooves to the substrate area exceeded 1/3, conspicuous advantages could be obtained. When the thickness of the oxide film 17 was increased, crystal defects occurred in the island regions 111 and the wafer 12. Since the island regions 111 and the oxide film 13 serve as a mask when the bottom of the groove is oxidized, crystal defects may occur by a mechanism similar to that of LOCOS defects. The defects do not occur when the thickness of the oxide film 17 is 90% or less of that of the oxide film 13.

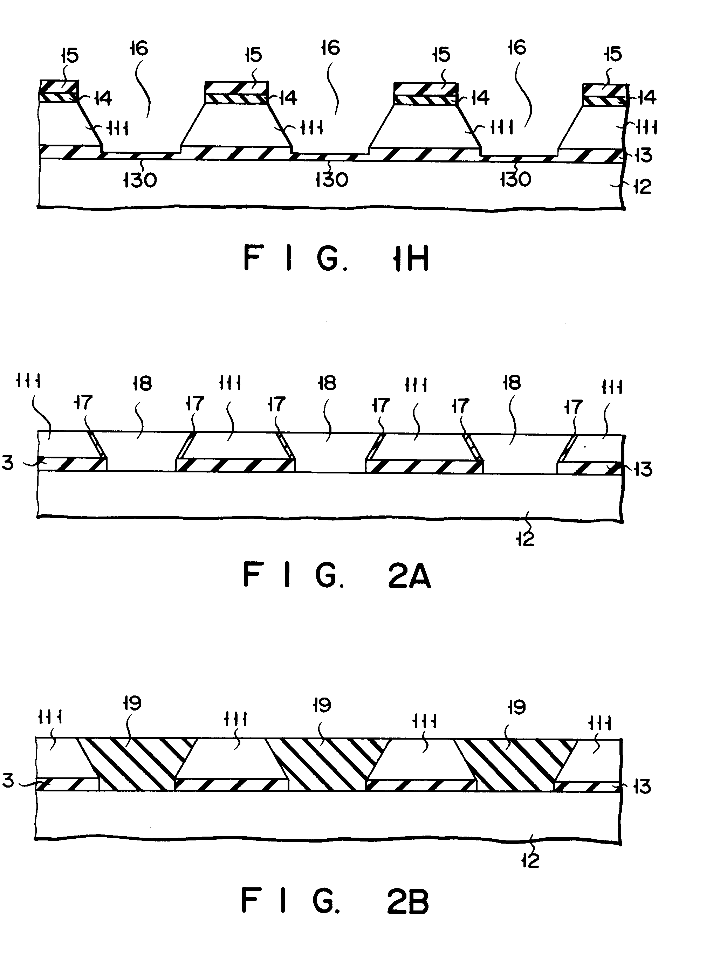

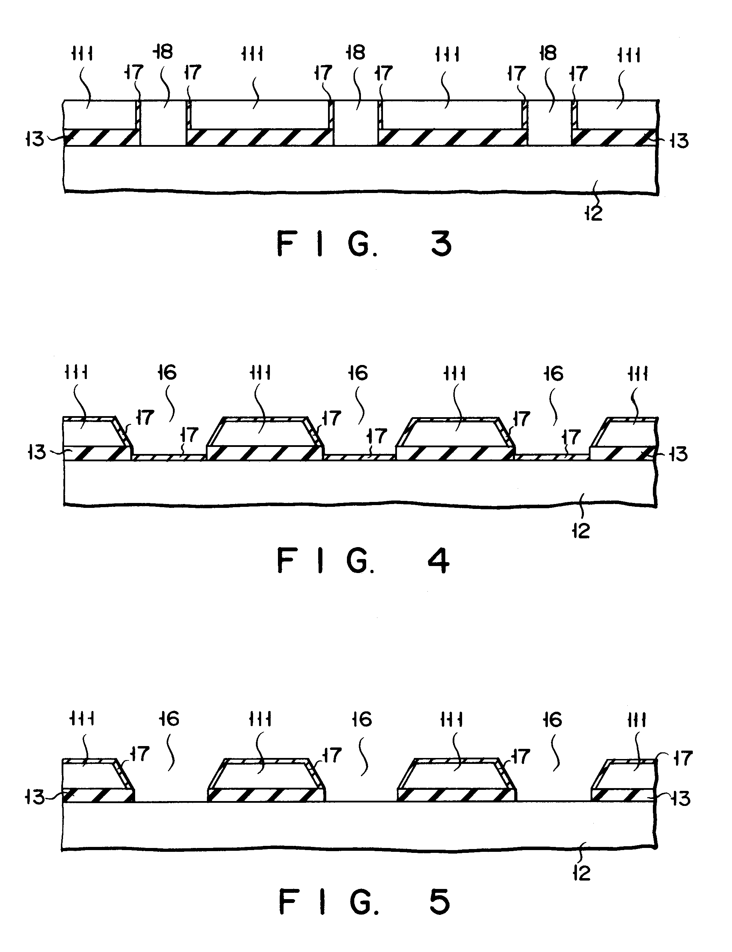

A semiconductor substrate according to the second embodiment of the present invention will be described below with reference to Figs. 2A, 2B, and 3. In Fig. 2A, the oxide film 17 of the first embodiment is not formed on the bottom of the groove 16, and the oxide film 17 are formed on only the side surface of the groove 16. Although the groove 16 having a V-shaped section is used in the first embodiment, a groove 16 having vertical side surface and formed by, e.g., an RIE (Reactive Ion Etching) technique are used as shown in Fig. 3. The thin film 17 is formed on only the side surface of the groove 16. According to the second embodiment, since an oxide film is entirely removed from the bottom of the groove 16, the warpage of the wafer is greatly reduced, and a polysilicon layer 18 buried in the groove 16 can be electrically connected to the support wafer 12. In order to stabilize the characteristics of circuit elements formed in silicon island regions 111, the polysilicon layer 18 buried in the groove 16 and the support wafer 12 are generally kept at a ground potential. According to the first embodiment, since the polysilicon layers 18 is insulated from the wafer 12 by the oxide film 17, a wiring layer must be arranged to decrease the potential of the polysilicon layer 18 to the ground potential. However, according to the second embodiment, this wiring layer is not necessary.

As shown in Fig. 2B, the grooves 16 between the island regions 111 may be buried with an insulating material 19 such as resin.

A semiconductor substrate according to the third embodiment of the present invention will be described below with reference to Figs. 4 and 5. In the embodiment, the semiconductor substrate has a structure similar to the structure shown in Figs. 1G, 2A, and 2B. In the third embodiment, grooves 16 are not buried with a polysilicon layer 18, and the isolation is performed while exposing the groove 16. The structure is often used in a case where the thickness of the wafer 11 or the island region 111 is thin. In the second and third embodiments, the same advantages as described in the first embodiment can be obtained.

The present invention is not limited to the above embodiments, and various modifications can be provided. For example, the substrate obtained such that silicon substrates are integrally bonded to each other through the oxide film by the direct bonding technique has been described in the above embodiments. The present invention can be applied to a substrate obtained such that silicon substrates are integrally bonded through a dielectric film having a thermal expansion coefficient different from that of the silicon substrates by another bonding method such as electrostatic bonding techniques and CVD glass bonding techniques.

As described above, according to the present invention, the thick oxide film is located only between island regions, which are made of silicon and in which circuit elements are to be formed, and the support substrate, and the oxide film on the bottom of the groove for isolating the island regions from each other has a thin thickness or is removed. Therefore, the warpage of the wafer can be greatly reduced, processing precision can be improved, and the wafer having the large diameter can be obtained.

It is further understood by those skilled in the art that the foregoing description is preferred embodiments and that various changes and modifications may be made in the invention without departing from the spirit and scope thereof.

**Claims**

1.  A semiconductor substrate having dielectrically isolated island regions (111) including a first semiconductor substrate (11) for providing circuit elements, a second semiconductor substrate (12) for supporting said first semiconductor substrate (11), an insulating film (13) located between said first and second semiconductor substrates (11, 12), and a plurality of grooves (16) formed in said first semiconductor substrate (11) to expose a surface of said second semiconductor substrate (12), characterized in that a plurality of island regions (111) are provided above said second semiconductor substrate (12) through only said insulating film (13).

2.  The semiconductor substrate according to claim 1, characterized in that a side surface of each of said island regions (111) is covered with a thin insulating film (17).

3.  The semiconductor substrate according to claim 2, characterized in that said grooves (16) are filled with an insulating material (19).

4.  The semiconductor substrate according to claim 1, characterized in that each of said grooves (16) has a V-shaped structure.

5.  The semiconductor substrate according to claim 1, characterized in that each of said grooves (16) is comprised of a trench.

6.  The semiconductor substrate according to claim 2, characterized in that said grooves are filled with polysilicon (18).

7.  A semiconductor substrate having dielectrically isolated island regions (111) including a first semiconductor substrate (11) for providing circuit elements, a second semiconductor substrate (12) for supporting said first semiconductor substrate (11), a first insulating film (13) located between said first and second semiconductor substrates (11, 12), a plurality of grooves (16) formed in said first semiconductor substrate (11) to provide a plurality of island regions (111), and a second insulating film (17) provided on said second semiconductor substrate (12),
    characterized in that said plurality of island regions (16) are provided above said second semiconductor substrate (12) through said first insulating film (13) and that said second insulating film (17) is thinner than said first insulating film (13).

8.  The semiconductor substrate according to claim 7, characterized in that a side surface of each of said island regions (111) is covered with said second insulating film (17).

9.  The semiconductor substrate according to claim 8, characterized in that said grooves (16) are filled with polysilicon (18).

10. The semiconductor substrate according to claim 7, characterized in that each of said grooves (16) has a V-shaped structure.

11. The semiconductor substrate according to claim 7, characterized in that each of said grooves (16) is comprised of trench.

12. A method of making a semiconductor substrate having dielectrically isolated island regions (111) comprising the steps of:
    preparing first and second semiconductor substrates (11, 12);
    forming an insulating film (13) on a surface of at least one of said first and second semiconductor substrates (11, 12);
    directly bonding said first semiconductor substrate (11) to said second semiconductor substrate (12) through said insulating film (13); and
    forming grooves (16) in said first semiconductor substrate (11) to provide a plurality of island regions (111) on said second semiconductor substrate (12).

13. The method according to claim 12, characterized in that said forming grooves (16) in said first semiconductor substrate (11) includes the step of removing said insulating film (13) to a desired thickness.

14. The method according to claim 12, characterized in that said forming grooves (16) in said first semiconductor substrate (11) includes the step of removing said insulating film (13) to expose a surface of said second semiconductor substrate (12).

15. The method according to claim 13, characterized in that said grooves (16) are filled with an insulating material (19).

16. The method according to claim 14, characterized in that a thin insulating film (17) is formed on the exposed surface of said second semiconductor substrate (12).

17. The method according to claim 16, characterized in that a thin insulating film (17) is formed on a side surface of each of said island regions (111).

18. The method according to claim 17, characterized in that said grooves (16) are filled with polysilicon (18).

19. The method according to claim 16, characterized in that said thin insulating film (17) is thinner than said insulating film (13).

F I G. 1A

F I G. 1B

F I G. 1C

F I G. 1D

7

F I G.  1E

F I G.  1F

F I G.  1G

F I G. 1H

F I G. 2A

F I G. 2B

9

F I G. 3

F I G. 4

F I G. 5

F I G. 6A

F I G. 6B

F I G. 6C

F I G. 6D

F I G. 7